(19) **Europäisches Patentamt**
**European Patent Office**
**Office européen des brevets**

(11) **EP 2 069 814 B1**

(12) **FASCICULE DE BREVET EUROPEEN**

(45) Date de publication et mention
de la délivrance du brevet:
**23.03.2011 Bulletin 2011/12**

(21) Numéro de dépôt: **07820965.7**

(22) Date de dépôt: **05.10.2007**

(51) Int Cl.:
***G01R 31/3185*** *(2006.01)* ***G01R 31/30*** *(2006.01)*

(86) Numéro de dépôt international:
**PCT/EP2007/060591**

(87) Numéro de publication internationale:
**WO 2008/040798 (10.04.2008 Gazette 2008/15)**

(54) **REGISTRE SCAN PARAMETRIQUE, CIRCUIT NUMERIQUE ET PROCEDE DE TEST D'UN CIRCUIT NUMERIQUE A L'AIDE D'UN TEL REGISTRE**

PARAMETRISCHES SCAN-REGISTER, DIGITALE SCHALTUNG UND VERFAHREN ZUM PRÜFEN EINER DIGITALEN SCHALTUNG UNTER VERWENDUNG EINES SOLCHEN REGISTERS

PARAMETRIC SCAN REGISTER, DIGITAL CIRCUIT AND METHOD FOR TESTING A DIGITAL CIRCUIT USING SUCH REGISTER

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **06.10.2006 FR 0608798**

(43) Date de publication de la demande:
**17.06.2009 Bulletin 2009/25**

(73) Titulaire: **Commissariat à l'Énergie Atomique et aux Énergies Alternatives 75015 Paris (FR)**

(72) Inventeurs:
• **HERON, Olivier**
**F-78830 Bullion (FR)**
• **BONHOMME, Yannick**
**F-91530 Le Val Saint Germain (FR)**

(74) Mandataire: **Lucas, Laurent Jacques**
**Marks & Clerk France**
**Conseils en Propriété Industrielle**
**Immeuble " Visium "**
**22, avenue Aristide Briand**
**94117 Arcueil Cedex (FR)**

(56) Documents cités:
**US-A1- 2003 208 708**

**Description**

La présente invention concerne un registre scan paramétrique comprenant au moins une cellule scan paramétrique. Elle concerne également un procédé de test d'un circuit numérique à l'aide d'un tel registre. Elle concerne enfin un circuit numérique équipé d'au moins un registre scan paramétrique ou une cellule scan paramétrique. L'invention s'applique notamment pour le test de circuits intégrés à forte densité d'intégration, par exemple dans le domaine des nanotechnologies.

Si on considère le cas des circuits intégrés (Cls) numériques, un objectif des tests est de rejeter des Cls défaillants durant un flot de fabrication, c'est-à-dire des Cls ne répondant pas aux spécifications souhaitées. On entend par CI numérique un circuit intégré réalisant une fonction spécifique, par exemple un circuit du type ASIC (Application Specific Integrated Circuit). Il est connu d'appliquer des stimuli ou vecteurs de test sur les entrées d'un CI et d'analyser par la suite les réponses. Si les réponses observées sont comparables à celles attendues alors le test conclut à un succès, sinon le CI est considéré comme défectueux.

Un test exhaustif permet de détecter le maximum de défauts. Ce type de test est néanmoins très coûteux en terme de temps, en effet le nombre de vecteurs croît en puissance de 2 avec le nombre d'entrées. Des méthodes de test ont été proposées dans la littérature avec pour objectif de minimiser le temps de test par Cl. Ces méthodes peuvent être classées en deux catégories selon l'approche adoptée : test fonctionnel ou test structurel. Dans la première approche, les vecteurs de test sont justifiés par la fonction digitale du CI à tester. Dans l'approche de test structurel, le but est non plus de vérifier la fonction du CI mais sa structure. Pour cela les vecteurs de test sont générés à partir de modèles représentant des comportements fautifs de la structure du CI.

Les modèles utilisés dans le test structurel sont appelés fautes et représentent des mécanismes de défaillance dus à des défauts physiques. Par exemple, le modèle de faute de collage à 0, ou 1, représente un défaut de type court-circuit franc d'une ligne du circuit à une équipotentielle à 0, ou à 1, comme décrit notamment dans l'ouvrage de C. Landrault « Test de Circuits et de Systèmes Intégrés », Chap. 2, pp. 60-62, Editions Lavoisier, 2004. D'autres modèles ont été proposés afin de couvrir le maximum de défauts physiques tels que le modèle de fautes de délai pour la prise en compte de « retards », notamment décrit l'article de M.A. Breuer « The Effects of Races, Delays and Delay Faults on Test Generation », IEEE Trans. On Computers, Vol. 23, pp. 1078-1092, Octobre 1974. Bien que ces tests permettent de détecter un large éventail de défauts physiques pendant la phase de fabrication, l'avancée dans la miniaturisation des Cls induit d'autres défauts qui ne sont pas détectés par ces tests.

D'autres méthodes de test sont encore connues comme le test de courant notamment décrit dans l'ouvrage de C. Landrault précité au chapitre 5, pp. 148-153. Ce test consiste à détecter une surconsommation en courant du circuit dans un état connu. Cette approche est envisageable si la consommation dynamique reste suffisamment supérieure aux courants statiques d'un transistor. Une utilisation conjointe de ces méthodes de test permet de détecter la majorité des défauts physiques dans les Cls en technologie submicronique.

Avec l'accroissement du nombre de fonctions intégrées dans un même substrat de silicium, les techniques de test actuelles ne peuvent pas garantir une couverture complète de défauts dans un temps acceptable. Afin de limiter la complexité des tests de production, des techniques de conception des Cls en vue de ces tests ont été proposées dans la littérature. Ces techniques permettent d'améliorer la capacité de test des Cls. L'insertion de chaînes dite de Scan est une solution couramment utilisée. Elle permet notamment de faciliter le test des Cls en améliorant leur contrôle et leur observabilité comme le montre l'ouvrage de C. Landrault au chapitre 7, pp. 200-210 ou l'article de M. William et J. Angel « Enhancing testability of LSI Circuits via Test Points and Additional Logic », IEEE Trans. On Computers, Vol. C-22, n° 1, janvier 1973. Le principe de l'insertion de chaînes de Scan consiste à modifier la structure des registres mémoires d'un CI en un registre Scan. Ce registre possède deux modes de fonctionnement : test et normal. Dans le mode test, les registres Scan proposent un accès en série. L'entrée et la sortie de la chaîne permettent respectivement le chargement et le déchargement en série de vecteurs de test et des réponses, via les entrées et les sorties de test. Dans le mode normal, le fonctionnement du registre est conservé, rendant l'insertion de chaînes de Scan transparente pour le fonctionnement du CI.

Cependant, l'application de ces techniques de test classiques ne permet pas de garantir que le circuit sera exempt de défaillance pendant son utilisation. Ce phénomène s'accentue avec l'utilisation des nanotechnologies. En effet, le nombre de défaillances dynamiques augmente avec la réduction des tailles des transistors. Ce type de défaillance peut être dû à des défauts induits, c'est-à-dire des mécanismes de défaillances résultant de phénomènes de diaphonie entre des composants internes du circuit ou avec l'environnement extérieur. Il peut aussi être dû à l'usure rapide du CI qui se traduit par l'apparition de phénomènes physiques, par exemple une électromigration ou encore une corrosion de l'oxyde.

Ainsi, si l'accroissement de la densité d'intégration des CI numériques permet d'y insérer un nombre croissant de fonctions, on constate en contrepartie une forte augmentation de la probabilité de manifestation de défauts permanents, ou de fabrication, et de défauts transitoires, en cours de fonctionnement. De tels défauts peuvent induire des défaillances pouvant être inacceptables dans certains domaines d'application. Un test, sous toutes ses variantes telles que décrites précédemment, permet d'améliorer la fiabilité des CIs.

Cependant, avec l'arrivée des « nanotechnologies », de nouveaux problèmes technologiques se posent sur la fiabilité des CIs. Parmi les principaux problèmes, on peut citer :

- la complexité du test qui a tendance à augmenter de manière quasi-exponentielle avec le nombre de portes logiques ou de transistors des CIs, rendant d'autant plus important les coûts de développement des CIs ;
- la réduction de la taille des procédés de fabrication qui implique inévitablement une diminution de la robustesse de la technologie utilisée, ce qui se traduit notamment par la manifestation de nouveaux défauts sur la structure pour lesquels les techniques de test actuelles ne permettent pas leur détection ;
- le comportement plutôt analogique des CIs en technologie nanométrique qui montre que certains mécanismes de défaillance, auparavant masqués dans les technologies submicroniques, deviennent prépondérants, en particulier, les phénomènes transitoires et les bruits engendrés par l'environnement extérieur ou la structure elle-même deviennent prépondérants pendant le fonctionnement d'un CI, normal ou sous test.

Dans la suite du document, on entend par cellule un élément de mémoire unitaire d'un CI. Une cellule mémoire comporte typiquement une bascule et des éléments de structure.

Un registre est un opérateur logique composé de n cellules présentant chacune une sortie logique, muni de commandes globales, d'inhibition ou de remise à zéro notamment. Il est destiné à garder momentanément en mémoire un nombre binaire de n chiffres. Un registre est composé d'au moins deux cellules mémoire qui peuvent ou non être chaînées entre elles. Une chaîne de scan est constituée par la mise en série, uniquement pour le test, des cellules dans un registre.

Un registre scan (RS) est composé de plusieurs cellules de scan. Un registre scan paramétrique (RSP) comporte plusieurs cellules de scan, dont au moins une cellule de scan paramétrique (CSP).

Un CI comporte au moins une cellule mémoire et généralement au moins un registre de plusieurs cellules.

Un document US 2003/208708 A1 décrit un circuit une une méthode de test paramétrique utilisant des registres scan.

Un but de l'invention est notamment de répondre à ces problèmes. A cet effet, l'invention a pour objet un registre scan comportant une cellule mémoire scan paramétrique ayant au moins une entrée de donnée d, apte à recevoir une donnée de test e_scan, et transférant sur sa sortie s un signal représentatif de la donnée d'entrée au moyen d'un signal de synchronisation, la cellule scan comporte en outre un bloc de test paramétrique dont une entrée est reliée à la sortie s de la cellule mémoire, le signal de sortie s de la cellule étant transféré en sortie s_reg du bloc à travers un module interne, ce module interne fonctionnant selon des modes aptes à modifier les propriétés du signal de sortie de la cellule CSP.

Avantageusement, la sortie s_reg du bloc de test paramétrique forme par exemple la sortie de ladite cellule scan paramétrique.

Plusieurs modes de fonctionnement du bloc de test paramétrique sont possibles. Dans un mode de fonctionnement normal, le signal de sortie de la cellule mémoire est, par exemple, transféré en sortie du bloc sans modification. Dans d'autres modes, un retard est appliqué sur le signal de sortie de la cellule mémoire, sur la pente ou sur l'état transitoire, ce retard pouvant être infini de telle sorte que la sortie du bloc de test paramétrique affiche la valeur précédemment présente avant le front d'horloge. Dans d'autres modes, une modification d'amplitude est appliquée sur le signal de sortie de la cellule mémoire. Ces modifications sont, par exemple, effectuées par un module interne au bloc de test paramétrique.

Dans une variante de réalisation, le bloc de test paramétrique comporte par exemple un module de génération de signaux arbitraires, ces signaux étant transférés sur la sortie du bloc. Selon les modes précédents des modifications peuvent être appliquées aux signaux arbitraires, ces derniers pouvant par ailleurs être fournis par un générateur extérieur.

La cellule scan comporte par exemple en entrée un multiplexeur dont la sortie est reliée à l'entrée d de la cellule mémoire, une entrée du multiplexeur recevant la donnée de test e_scan, la donnée de test e_scan étant sélectionnée en sortie du multiplexeur par une entrée de contrôle ctrt_NormTest.

L'invention a également pour objet un circuit intégré numérique comportant au moins un registre scan paramétrique tel que défini précédemment. Avantageusement, ce circuit numérique comporte par exemple un contrôleur générant des signaux de sélection des modes de fonctionnement du bloc de test paramétrique.

L'invention a également pour objet un procédé de test d'un circuit intégré numérique comportant des registres scan dont au moins un registre scan tel que défini précédemment, le procédé comportant au moins les étapes suivantes :

- charger au moins un vecteur de test dans les registres scan ;
- sélectionner un mode de fonctionnement du bloc de test paramétrique équipant le ou les registres scan (CS) ;
- valider le mode de fonctionnement pour modifier le signal d'entrée du bloc avant sa propagation dans le circuit numérique ;

- analyser le signal en sortie du chemin sous test, le chemin sous test étant situé entre la sortie s_reg et une sortie primaire ou secondaire du CI.

En option il est possible de prévoir, en fonction du mode de test choisi de prévoir une étape de chargement d'un vecteur de sensibilisation pour agir sur la commutation des cellules scan paramétriques. En d'autres termes, le procédé comporte en outre une étape supplémentaire entre l'étape de validation du mode de fonctionnement et l'étape d'analyse du signal en sortie du chemin sous test, cette étape consistant à charger un vecteur de sensibilisation pour agir sur la commutation de ou des cellules formant un registre scan paramétrique. Un vecteur de test est par exemple un mot binaire de n bits où n est le nombre de cellules scan dans le registre.

D'autres caractéristiques et avantages de l'invention apparaîtront à l'aide de la description qui suit faite en regard de dessins annexés qui représentent :

- la figure 1, une illustration d'un modèle générique de CI numérique séquentiel ;
- la figure 2, une présentation par un schéma de principe d'une cellule mémoire simple d'un registre ;
- la figure 3, une présentation d'une cellule scan selon l'art antérieur d'un registre scan ;
- la figure 4, une présentation d'un exemple de cellule scan paramétrique selon l'invention ;
- la figure 5, une illustration d'un premier mode de fonctionnement d'une cellule scan paramétrique selon l'invention ;
- la figure 6, une illustration d'un mode de fonctionnement appliquant des délais ;
- la figure 7, une illustration d'un mode de fonctionnement appliquant des modifications de niveau d'amplitude ;
- la figure 8, une illustration d'un mode de fonctionnement combinant les deux modes précédents ;
- la figure 9, un autre exemple de réalisation d'une cellule scan paramétrique selon l'invention générant notamment des signaux arbitraires ;
- la figure 10, un exemple de mise en oeuvre d'un procédé de test paramétrique selon l'invention ;
- la figure 11, un état des cellules scan contenues dans un registre lors du chargement d'un vecteur de test ;
- la figure 12, une illustration d'un résultat de test observée dans les cellules du registre du registre scan précité.

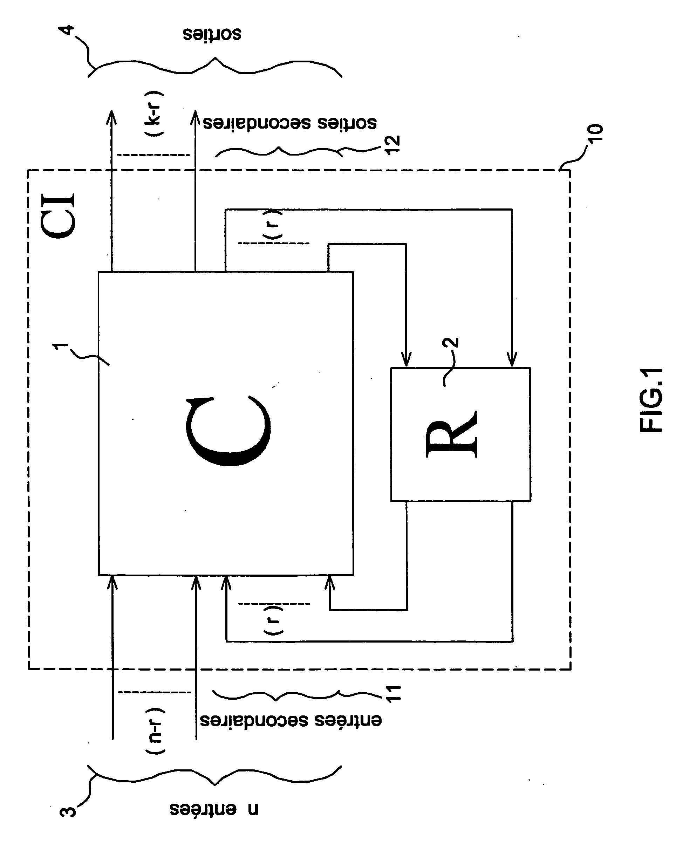

La figure 1 illustre un modèle générique de représentation d'un CI numérique 10. La fonction réalisée par un CI numérique peut se représenter sous la forme d'une machine de Moore ou de Mealy telle que décrite notamment dans le document de E.F. Moore « Sequential Machines : Selected Papers », Addison Wesley, Reading, MA, 1964. Dans ces deux modèles, le CI est divisé en deux parties : une partie combinatoire 1 et une partie registre 2. La partie combinatoire peut se représenter par une fonction logique à n entrées 3 et k sorties 4. La partie registre 2 regroupe r cellules mémoires dont les entrées, respectivement les sorties, sont connectées à r sorties 12, ou entrées 11, secondaires de la partie combinatoire 1. Plus précisément, les r entrées de la partie registre 2 sont reliées à r sorties secondaires parmi les k sorties de la partie combinatoire 1. De même, les r sorties de la partie registre 2 sont reliées à r entrées secondaires parmi les n entrées de la partie combinatoire. Il s'ensuit que $r < n$ et $r < k$. Les cellules mémoires de la partie registre 2 contiennent les états successifs du CI.

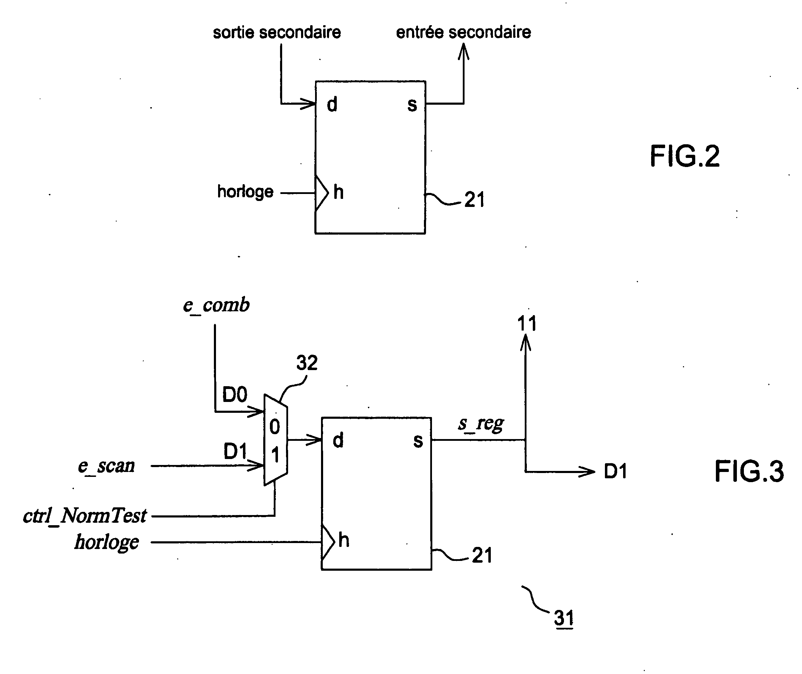

La figure 2 présente par un schéma de principe une cellule mémoire simple 21 avec un bit de donnée. Une telle cellule dispose d'une entrée de donnée d, d'une sortie s permettant la lecture de la mémoire et d'une entrée de signal d'horloge de synchronisation h. On suppose que l'écriture d'une donnée dans la cellule 21 s'effectue sur le front montant du signal d'horloge. L'écriture pourrait aussi s'effectuer sur le front descendant du signal d'horloge, ou sur ses niveaux haut et bas. Un chaînage de cellules mémoire simples 21 peut être effectué au niveau de la partie registre 2. En particulier, une entrée d d'une cellule 21 peut être reliée à une sortie secondaire 12 et une sortie s de la cellule peut être reliée à une entrée secondaire 11.

La figure 3 présente une cellule scan classique 31, simple, selon l'art antérieur. Cette cellule 31 comporte une cellule mémoire simple 21 du type de celle de la figure 2 et un multiplexeur simple 32 à 1 bit de contrôle. La sortie du multiplexeur 32 est connectée sur l'entrée de donnée d de la cellule 21. Une première entrée de donnée D0 du multiplexeur est connectée à une sortie secondaire de la partie combinatoire 1, notée e_comb, et l'autre entrée de donnée D1 est connectée à la sortie de la cellule mémoire adjacente, notée e_scan. Les cellules ainsi chaînées forment un registre scan. L'entrée de sélection du multiplexeur 32 est reliée à une entrée externe, notée ctrl_NormTest. Cette entrée supplémentaire prévue dans un CI à tester permet notamment de sélectionner le mode normal ou le mode test du registre scan. Dans le mode normal, l'entrée D0 est sélectionnée en sortie du multiplexeur. Dans le mode scan, l'entrée D1 est sélectionnée.

La sortie de la cellule scan, qui est aussi la sortie de la cellule mémoire simple 21, notée s_reg, est connectée à une entrée secondaire 11 de la partie combinatoire et, si cela est prévu, à l'entrée D1 de la cellule scan suivante. La cellule scan 31 génère sur sa sortie s_reg des signaux classiques booléens, type 0 et 1. La plupart des techniques de test de l'art antérieur exploitent des vecteurs de test booléens. Pour cela elles utilisent des cellules mémoire scan du type de celui de la figure 3 qui permettent, en mode test, d'injecter dans les CIs des vecteurs de test de valeurs booléennes. Ces techniques visent notamment à minimiser le nombre de points d'entrées afin de réduire le nombre de tests qui

augmente en $2^n$ en fonction du nombre n d'entrées testées.

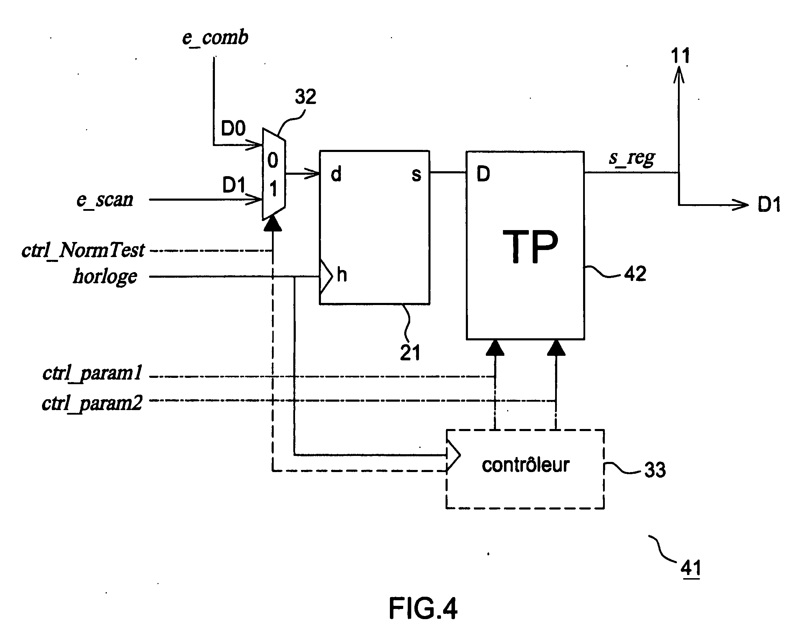

La figure 4 présente un exemple de cellule scan paramétrique (CSP) selon l'invention. Cette CSP 41 comprend notamment une fonctionnalité qui lui permet de générer en sortie des signaux particuliers en plus des signaux classiques booléens. Pour cela, la sortie s de la cellule mémoire 21 est connectée à un bloc de test paramétrique 42. Plus particulièrement la sortie s est reliée à une entrée de donnée D du bloc de test paramétrique. La sortie de ce bloc 42 constitue la sortie r_reg de la CSP 41. Ce bloc 42 comporte par ailleurs au moins une entrée supplémentaire pour sélectionner des modes de test paramétrique. Dans l'exemple de la figure 4, le bloc 42 comporte deux entrées de sélection des modes.

La sélection de quatre modes est assurée dans l'exemple de la figure 4 par deux entrées de contrôle ctrl_ param1 et ctrl_param2. Ces entrées de contrôle sont générées soit depuis l'extérieur, soit par un contrôleur embarqué 33, c'est-à-dire implanté dans le CI par exemple. Dans cette dernière option, l'entrée de sélection ctrl_NormTest du multiplexeur 32 pourrait être également commandée par ce contrôleur embarqué 33. L'horloge de synchronisation de la cellule mémoire 21 peut aussi par exemple permettre de synchroniser le contrôleur 33.

Une CSP selon l'invention telle qu'illustrée par la figure 4 possède, comme un CS classique, un mode normal et un mode test avec scan, noté Test-Scan.

- Dans le mode normal, le CSP est similaire à une cellule mémoire simple 21. L'entrée D0 du multiplexeur est sélectionnée et la sortie s_reg du CSP reproduit la sortie s du registre mémoire 21.
- Dans le mode Test Scan, la cellule mémoire est connectée en sortie à l'entrée d'une autre cellule mémoire, son entrée étant connectée à la sortie d'une cellule amont. Si la cellule est la première de la chaîne alors son entrée est reliée à l'entrée e_scan du registre. Si la cellule est la dernière de la chaîne alors sa sortie est connectée à la sortie du registre. Les cellules mémoires 21 situées dans une même chaîne partagent le même signal ctrl_NormTest. Dans ce mode, la forme, l'amplitude et les délais des signaux de sortie et d'entrée sont déterminés par la technologie utilisée.

En plus de ces deux modes, un CSP selon l'invention possède un mode de caractérisation, noté Test-Caractérisation mis en oeuvre notamment par le bloc de test paramétrique 42. Ce mode permet notamment d'appliquer des signaux non classiques dans un CI. Ce mode Test-Caractérisation comporte lui-même plusieurs modes. Ces modes sont sélectionnés par les entrées ctrl_paraml et ctrl_param2 du bloc de test paramétrique 42. Les figures suivantes illustrent les différents modes de fonctionnement de ce bloc 42, chacun de ces modes correspondant à un mode du mode Test-Caractérisation.

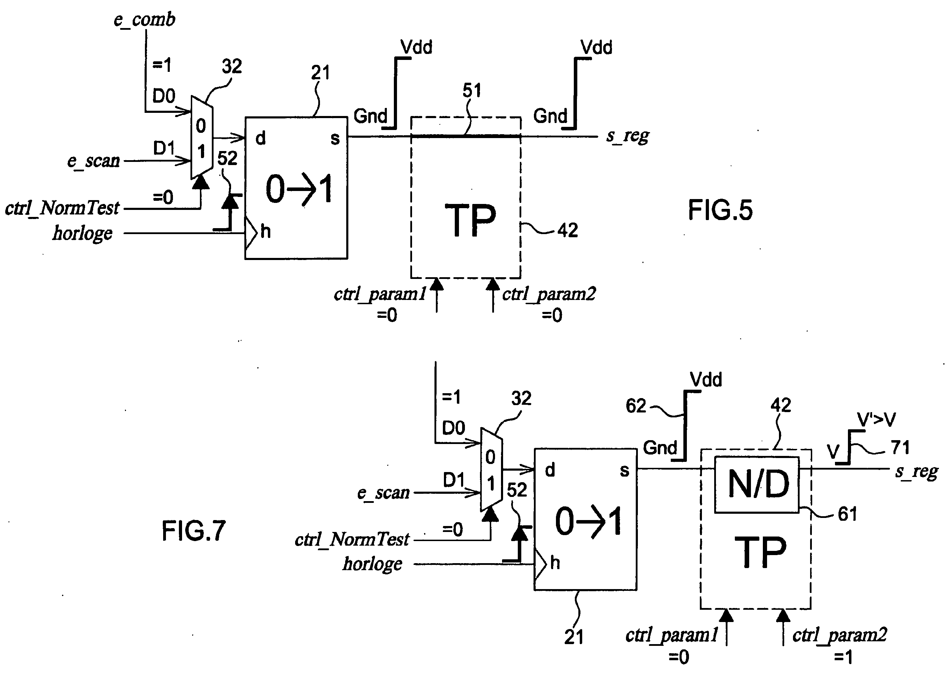

La figure 5 illustre un premier mode de fonctionnement du bloc de test paramétrique 42. Dans ce premier sous-mode, le mode Test-Caractérisation, est inhibé. Le bloc de test paramétrique 42 est alors transparent, c'est-à-dire que la sortie s de la cellule mémoire 21 est directement reliée à la sortie s-reg, par une liaison directe 51 par exemple. Ce mode est par exemple obtenu lorsque les deux entrées de sélection de mode ctrl_param1 et ctrl_param2 sont toutes deux à la valeur 0. Dans l'exemple de la figure 5, il est supposé qu'initialement la cellule mémoire 21 contient la valeur 0 et une valeur 1, présente à l'entrée D0 du multiplexeur 32, est présentée sur son entrée d. Au front montant d'horloge 52 par exemple, le mode activé dans le bloc 42 est validé dans la cellule mémoire et la sortie s commute de la valeur 0 à la valeur 1, en pratique d'un potentiel 0 à un potentiel Vdd par exemple, avec un temps de transition montant supposé nul ici. Cet exemple peut être étendu au cas dual où la sortie s passe de l'état 1 à l'état 0.

Dans ce mode où le bloc de test paramétrique 42 est transparent, la CSP fonctionne alors selon l'un des deux modes : normal ou Test-Scan, sélectionnés par l'entrée ctrl_NormTest du multiplexeur 42. Dans le mode normal, la CSP fonctionne comme une simple cellule mémoire. Dans le mode Test-Scan, la CSP fonctionne comme une cellule scan classique. La figure 5 illustre le cas du mode normal.

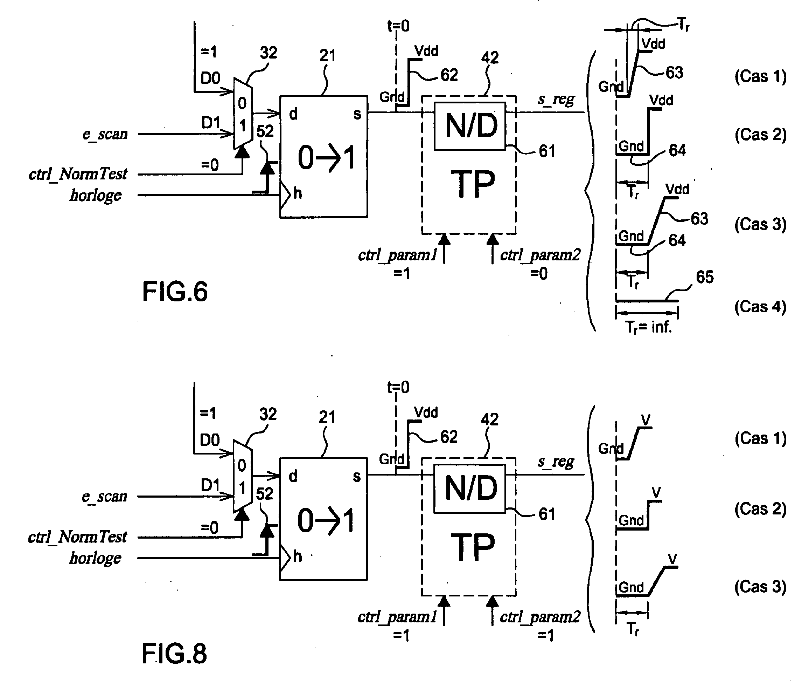

La figure 6 illustre un autre sous-mode du mode Test-Caractérisation, appelé mode Délai. Le mode Délai, mis en oeuvre par le bloc de test paramétrique 42, est par exemple activé lorsque les entrées de sélection ctrl_param1 et ctrl_param2 sont respectivement à 1 et à 0. Dans ce mode, la sortie s de la cellule mémoire 21 est connectée à l'entrée d'un module 61 interne au bloc de test paramétrique 42. Ce module interne 61 sera appelé par la suite module « Niveau/Délai ». La sortie de ce module 61 est reliée à la sortie s-reg du bloc 42 formant la sortie de la CSP. Ce module applique des retards sur le signal incident 62, à son entrée. Ce signal incident est le signal de sortie s de la cellule mémoire 21. Le module 61 applique les retards selon l'un des quatre cas suivants, illustrés notamment par la figure 6 pour un exemple de signal incident du type échelon montant :

- Cas 1 : le module « Niveau/Délai » applique un retard sur la pente du signal incident par ajout d'un retard Tr par exemple uniforme 63 sur le temps de transition montant Tm, ou descendant Td, du signal incident 62. Par exemple, le temps de montée retardé Tm' en sortie du module 61 vérifie Tm' = Tm + Tr.
- Cas 2 : le module applique un retard sur l'état transitoire e(t) du signal incident 62, l'état transitoire correspondant au passage d'un état stabilisé, par exemple 0, à un autre état stabilisé, par exemple 1. Les temps de transition, ou durées de l'état transitoire, restent inchangés. Le module ajoute un retard Tr, par exemple uniforme 64, au signal incident. En fonction du temps, le signal de sortie du module 62 vérifie s(t) = e(t - Tr).

- Cas 3 : ce cas est une combinaison des deux cas précédents. Un retard 63 est appliqué sur le temps de transition et un retard 64 est appliqué sur l'état transitoire.
- Cas 4 : ce cas correspond à une inhibition de la sortie. Dans ce cas, le retard appliqué 65 est infini. La sortie s-reg du bloc 42 ne commute pas et affiche la valeur précédemment présente avant le front montant d'horloge 52.

La figure 7 illustre un autre sous-mode du mode Test-Caractérisation, appelé mode Niveau. Ce bloc est par exemple mis en oeuvre par le module interne « Niveau/Délai » 61 du bloc de test paramétrique 42. Le mode Délai est activé lorsque les entrées de sélection ctrl_paraml et ctrl_param2 sont par exemple respectivement à 0 et à 1. La sortie s de la cellule mémoire 21 est toujours reliée au module 61 et la sortie de ce module est toujours reliée à la sortie s-reg. Dans ce mode, seules les amplitudes du signal incident 62 sont modifiées par le module « Niveau/Délai » 61. Deux types de modification d'amplitude peuvent être appliqués :

- Une dégradation du potentiel Vdd, représentant la valeur 1, en un potentiel V' tel que par exemple :

$$\frac{Vdd}{2} < V' \leq Vdd \qquad (1)$$

- Une dégradation du potentiel Gnd, représentant la valeur 0, en un potentiel tel que par exemple :

$$Gnd \leq V \leq \frac{Vdd}{2} \qquad (2)$$

et

$$V' < V$$

Dans ce mode Niveau, il est à noter que le module peut agir sur la valeur finale du potentiel du signal incident ou sur sa valeur initiale ou sur les deux valeurs. La figure 7 illustre le principe décrit ci-dessus dans le cas d'une action sur les valeurs initiale et finale du potentiel. Le signal de sortie de la cellule mémoire qui est le signal incident 62 du module 61 « Niveau/Délai » est donc modifié au niveau de la sortie s-reg en un signal 71 où le potentiel Gnd est remplacé par le potentiel V et le potentiel Vdd est remplacé par le niveau V'. Dans ce cas, le mode Niveau doit être activé avant la capture de la valeur 0 présente en sortie du registre mémoire 21.

Le module « Niveau/Délai » 61 peut avantageusement réaliser la combinaison du mode Délai et du mode Niveau.

La figure 8 illustre un autre sous-mode du mode Test-Caractérisation qui est cette combinaison des modes Délai et Niveau. Ce mode est par exemple sélectionné lorsque les deux entrées de sélection du bloc 42 ctrl_param1 et ctrl_param2 sont toutes deux à l'état 1. Dans ce mode, les amplitudes et les délais du signal incident 62 sont modifiés comme décrit précédemment dans les modes Délai et Niveau. La figure 8 illustre une combinaison des trois premiers cas de la figure 6 avec une modification de niveau où le potentiel Gnd passe au niveau de potentiel V tel que défini relativement à la figure 7.

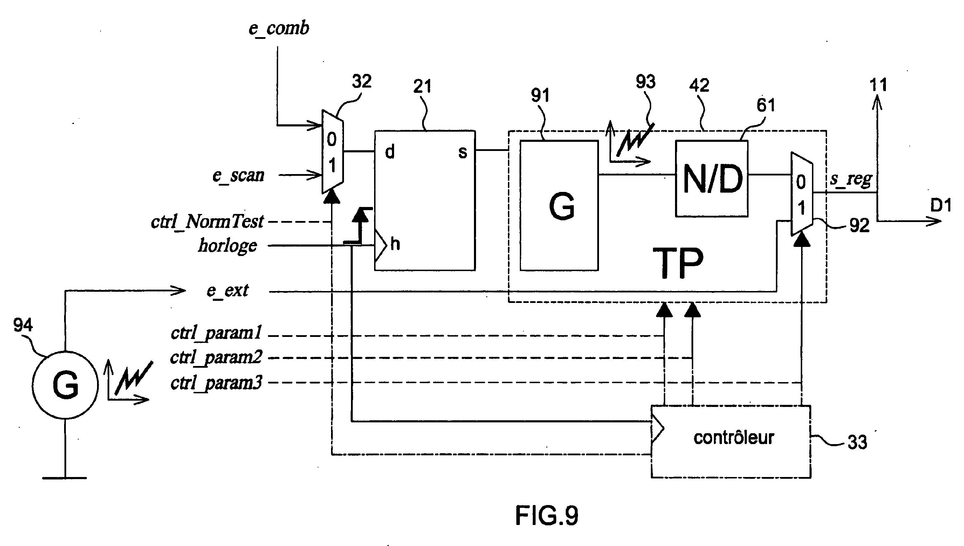

La figure 9 illustre un autre exemple de réalisation d'un RSP selon l'invention. Dans cet exemple de réalisation, le mode Test-Caractérisation possède un sous-mode supplémentaire appelé Int/Ext, mis en oeuvre par le bloc de test paramétrique 42. Pour permettre la réalisation de ce mode Int/Ext, un signal de sélection supplémentaire ctrl_param3 est ajouté. Ce signal, comme les deux autres signaux de sélection de mode ctrl_param1 et ctrl_param2 peut être fourni par l'extérieur ou par le contrôleur embarqué 33. Dans cet exemple de réalisation, la sortie s_reg de la CSP est reliée soit à une entrée externe e_ext de la cellule, soit à un deuxième module interne 91. La sortie s_reg est par exemple reliée à l'entrée e_ext lorsque le signal etrl_param3 est à l'état 0 et reliée au deuxième module interne 91 lorsque ctrl_param3 est à l'état 1. A cet effet, la sortie du deuxième module 91 et l'entrée externe e_ext sont par exemple connectées aux entrées d'un multiplexeur interne 92 dont l'entrée de sélection est commandée par le signal ctrl_param3.

La fonction du deuxième module 91 est notamment la génération de signaux arbitraires 93, c'est-à-dire des signaux autres que des signaux de type transition ou échelon. Dans ce type de module 91, la forme, l'amplitude et les délais des signaux à générer sont définis de manière explicite. Le signal extérieur e_ext est par exemple fourni par un générateur extérieur 94, ce dernier fournissant des signaux arbitraires.

L'exemple de réalisation de la figure 9 montre que la sortie du deuxième module 91 de génération de signaux arbitraires peut passer par le premier module 61 mettant en oeuvre les modes Niveau et Délai, ce qui permet en jouant sur les signaux de sélection ctrt_param1, ctrl_param2, ctrl_param3 de combiner les différents modes, et notamment d'appliquer des délais ou des modifications de niveaux aux signaux aléatoires.

Le bloc de test paramétrique 42 peut être réalisé à l'aidé de transistors de type MOS, de capacités et de résistances selon des techniques connues.

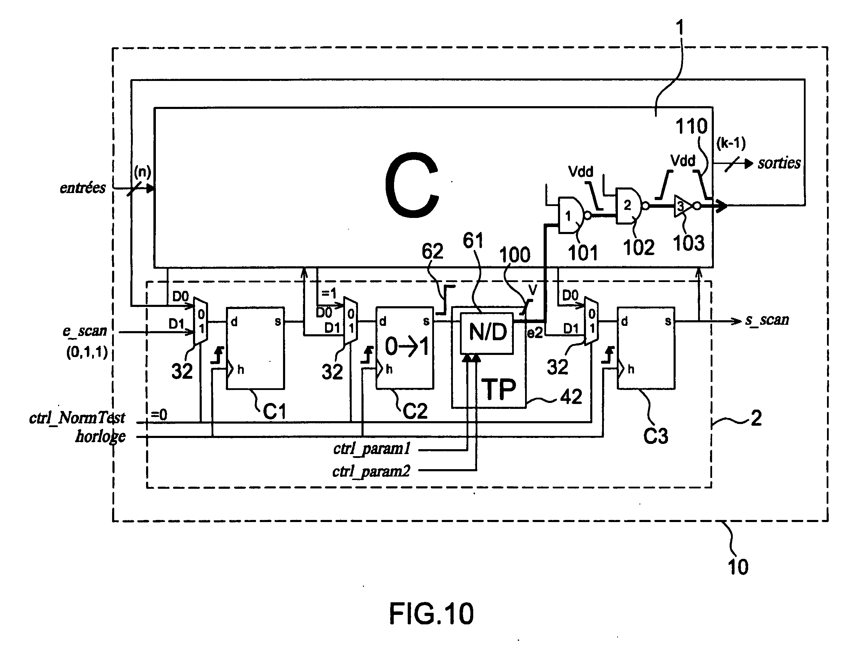

La figure 10 illustre une façon d'insérer un registre scan paramétrique (RSP) selon l'invention dans le flot de conception d'un CI 10, c'est-à-dire de définir une technique de conception du CI en vue du test paramétrique. Un test paramétrique selon l'invention peut s'utiliser au niveau logique, il présente notamment les caractéristiques suivantes :

- Il peut être général ou partiel : l'utilisation du test paramétrique n'implique pas nécessairement la transformation de chaque registre scan du CI en un RSP généralisé, ou « Full-Scan » selon la terminologie anglo-saxonne. La propriété de scan paramétrique partiel, ou pseudo-scan, signifie qu'une partie seulement des cellules mémoires du registre scan sont modifiées en des CSP tandis que les autres restent inchangées. Cette propriété permet un compromis entre la surface ajoutée et l'efficacité du test paramétrique souhaité.
- Il est flexible : chaque CSP insérée dans un registre peut avoir un fonctionnement différent. Par exemple, une première CSP peut être configurée dans le mode Délai tandis qu'une autre CSP est configurée dans le mode externe de Ext/Int. Cette propriété offre plusieurs degrés de flexibilité en termes de choix de test paramétrique. Chaque mode permet d'activer un mécanisme de sensibilisation particulier du CI.
- Il possède la propriété de modularité : chaque CSP peut n'offrir qu'un nombre limité de fonctionnalités parmi celles décrites précédemment. Par exemple, dans le cas d'un RSP composé de deux CSP, la première CSP peut inclure seulement le module « Niveau/Délai » 61 tandis que l'autre CSP .n'inclut pas ce module mais dispose d'une entrée externe supplémentaire e_ext. Il est à noter qu'une CSP pourrait n'offrir que la fonction scan classique et aucune fonction de test paramétrique. Cette dernière propriété permet également de limiter la surface ajoutée au CI par les circuits de test.

Le nombre de CSP à insérer dans un CI, et plus précisément dans chaque registre scan, le choix et la sélection des modes de chaque CSP sont notamment déterminés par la nature de la fonction, la structure et les spécifications du CI à tester.

L'exemple du CI 10 de la figure 10 illustre un fonctionnement possible du test paramétrique. Le CI comporte une partie combinatoire 1 et une partie registre 2 formant un registre scan paramétrique (RSP). Ce registre comporte trois cellules mémoires CI, C2, C3 du type de celle 21 illustrée par les figures précédentes. Parmi ces cellules, une seule C2, est équipée d'un bloc de test paramétrique 42 pour former une CSP. Les autres cellules CI, C3 incluent seulement la fonction scan classique, en étant équipé d'un multiplexeur 32 avec une entrée e_scan. Toutes ces cellules CI, C2, C3 sont chaînées en mode de test scan.

Dans le bloc 42 équipant la cellule C2, seul le module « Niveau/Délai » 61 est présent. Dans cet exemple, ce module 61 permet notamment de caractériser la sensibilité d'un chemin fonctionnel entre une entrée e2 et une sortie o2, intégré dans la partie combinatoire 1, pendant la phase de test de production. Ce chemin passe par exemple à travers plusieurs portes logiques 101, 102, 103. Un signal présent en e2 attaque une première porte 101, il est fourni en sortie du module « Niveau-Délai » 61 et donc en sortie du bloc de test paramétrique 42 du RSP. Ce signal e2 attaque par ailleurs l'entrée du multiplexeur 32 de la cellule suivante C3 dans la chaîne.

Cette caractérisation consiste par exemple à propager des signaux de type transition ou échelon avec des propriétés particulières telles que des délais ou des changements de niveau. A titre d'exemple, la caractérisation souhaitée consiste à générer une transition montante, avec une amplitude finale V et une amplitude initiale Gnd, un temps de transition montant Tm et un retard uniforme Tr sur le signal incident 62 sortant de la cellule C2 et entrant dans le module « Niveau/Délai » 61.

Dans une première étape, le vecteur de test est chargé dans le registre RSP 2, formé du chaînage des trois cellules C1, C2, C3, par l'entrée e_scan. Le vecteur de test est (0, 1, 1). Le chargement s'effectue en série par l'activation du mode Test-Scan. Dans ce cas, le signal ctrl_NormTest étant par exemple à 0, les multiplexeurs 32 des cellules mémoires sélectionnent l'entrée D1. L'entrée D1 de la première cellule C1 de la chaîne est reliée à l'entrée e_scan, puis les autres entrées D1 des autres cellules C2, C3 sont connectées aux sorties des autres cellules C1, C2 pour former le registre complet 2, chaîné. Pour mémoire, en mode normal, le signal ctrl_NormTest étant par exemple à 1, les entrées des cellules C1, C2, C3 sont reliées aux entrées D0 des multiplexeurs 32 elles-mêmes reliées à la partie combinatoire comme décrit relativement à la figure 1.

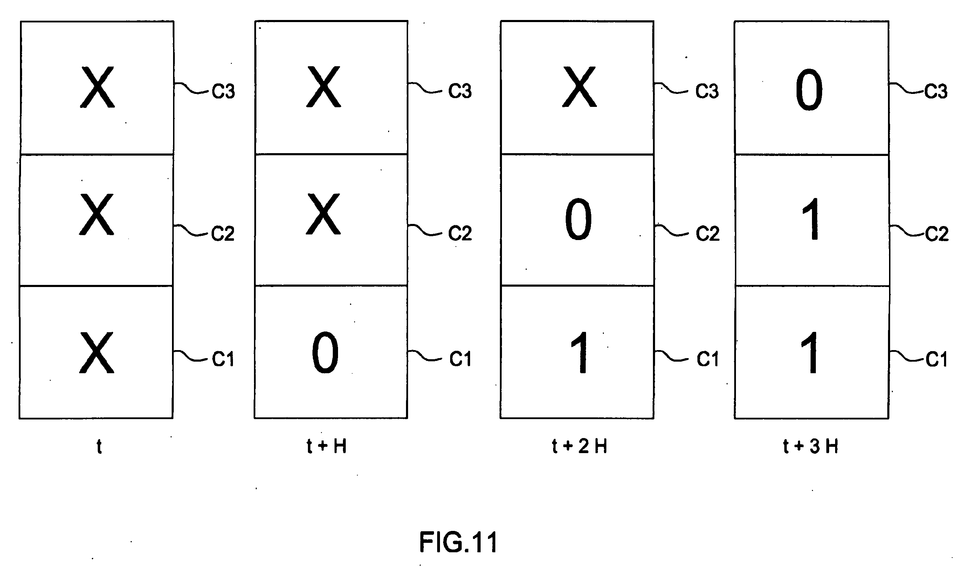

La figure 11 illustre l'état du registre RSP 2, et plus particulièrement l'état des cellules scan C1, C2, C3 à un instant t, et à des instants ultérieurs fonction des fronts d'horloges. A l'instant t, les cellules scan C1, C2, C3 sont dans un état indéterminé X. Aux fronts d'horloges suivants, définissant des instants incrémentés par l'intervalle de temps H, les états sont :

- à t + H, les cellules C1, C2, C3 sont respectivement à 0, X, X ;
- à t + 2H, les cellules C1, C2, C3 sont respectivement à 1, 0, X ;
- à t + 3H, les cellules C1, C2, C3 sont respectivement à 1, 1, 0 ;

On revient à la figure 10. A l'instant t + 3H, le vecteur de test est complètement chargé. La génération d'un échelon 62 sur la sortie de la cellule CSP C2 nécessite l'application de la valeur 1 sur son entrée. Cet échelon est nécessaire pour caractériser le chemin e2-o2. Dans l'exemple de la figure 6, l'échelon est généré via le mode Test-Scan en décalant vers la cellule C2 la valeur 1, contenue dans la cellule C1 à t + 2H. Ainsi, à t + 3H, la cellule C2 capture une valeur 1 sur son entrée. Les tests paramétriques sont par la suite appliqués sur le signal de sortie de la cellule C2, le signal modifié par le module « Niveau/Délai » 61 étant par la suite injecté dans le chemin e2-o2. Pour que le bloc 42 équipant la cellule C2 soit dans le bon mode de fonctionnement à l'instant t + 3H, le mode Test-Caractérisation est par exemple activé dans le bloc 42, plus particulièrement dans le module interne 61 « Niveau/Délai », à l'instant t + 2H, par la mise à l'état des 1 des signaux de sélection ctrl_param1 et ctrl_param2. Ainsi, à t + 3H, le mode est validé dans le bloc 42 et un échelon montant 62 est présent sur l'entrée de ce bloc. La procédure de caractérisation débute donc à cet instant. Pour les entrées ctrl_param1 et ctrl_param2 données, les modes Délai et Niveau du bloc 42 sont sélectionnés. Les valeurs V, Tm et Tr à appliquer au signal incident 62 sont mémorisées dans le module interne 61. Sur la sortie s_reg du CSP, il apparaît alors un signal de type transition montante 100 avec les paramètres V, Tm et Tr formant le signal présent à l'entrée e2.

Le signal en e2 ayant transité par exemple par trois portes d'inversion de signal 101, 102, 103 jusqu'à la sortie o2, il apparaît à cette sortie un front descendant 110 ayant une amplitude de pleine échelle Vdd et retardée d'un temps $T_0$ par rapport au signal source 62 en sortie de la cellule C2. L'amplitude Vdd dépend de la porte de sortie 103 en o2. Le retard $T_0$ est dû au cumul des délais $\Sigma t_i = \Delta T$ du chemin caractérisé e2-o2 et aux retards $t_v$, $t_{Tm}$, $t_{Tr}$ générés par le module « Niveau/Délai » 61, $\Delta T$ étant le délai normal du chemin sans défaut. Les retards $t_v$, $t_{Tm}$, $t_{Tr}$ sont respectivement générés par l'application de l'amplitude V et des retards Tm et Tr au signal incident 62, ces paramètres V, Tm et Tr ayant été définis lors de la présentation des différents sous-modes du mode Test-Caractérisation. Le retard $T_0$ est notamment défini par la relation suivante :

$$T_0 = \Sigma t_i + t_V + t_{Tm} + t_{Tr} \qquad\qquad (3)$$

Pour observer le résultat du test, la sortie o2 est connectée à l'entrée D0 du multiplexeur 32 de la cellule C1, cette entrée ayant été sélectionnée préalablement par le signal ctrl_NormTest.

Au bout du temps $\Delta T$, la cellule C1 capture la valeur 0 présente à la sortie o2 si le CI est sain. Par contre, si le signal propagé sur le chemin e2-o2 met en évidence un défaut présent et que ce défaut produise une dégradation sur l'amplitude finale du signal en sortie o2 et/ou ajoute un retard supplémentaire, alors la cellule C1 capture une valeur erronée, ou erreur logique, c'est-à-dire une valeur 1 au lieu de la valeur 0 attendue.

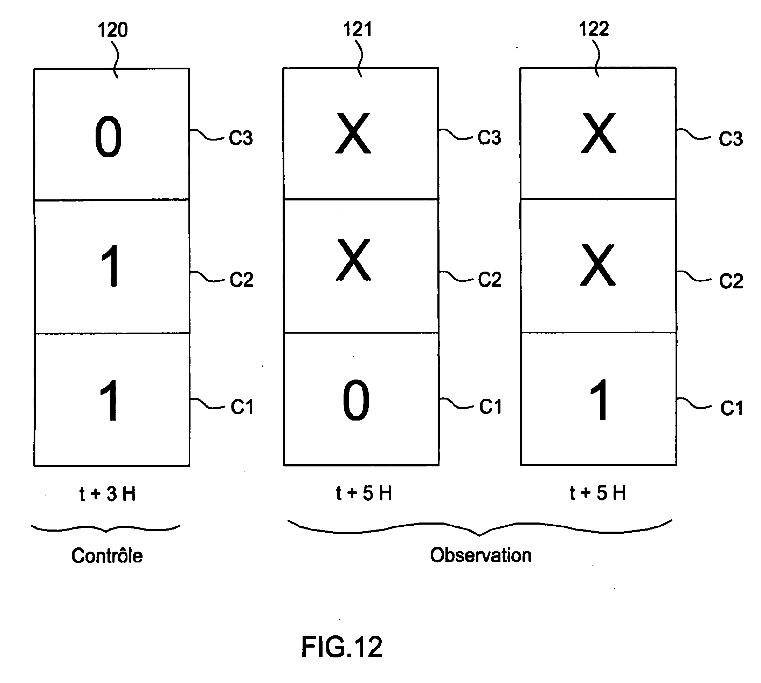

La figure 12 illustre l'observation du résultat du test effectué sur un circuit du type de la figure 10, dans un cas sans défaut et dans un cas avec défaut. Dans une phase de contrôle, à t + 3H, la cellule C2 est à l'état 1, l'ensemble des cellules 120 reproduisant le vecteur de test (0, 1, 1). Comme décrit précédemment le signal correspondant en sortie va transiter jusqu'à la sortie o2. Dans la phase d'observation, on scrute l'état de la cellule C1 ayant capturé la valeur en sortie o2 à un instant $T_{OBS}$ = t + 3H + $\Delta T$. Dans le cas 121 où le CI est sain, la cellule C1 contient la valeur 0, les autres cellules C2, C3 ayant par exemple une valeur indéterminée X. Dans le cas 122 où le CI présente un défaut sur le chemin e2-o2, la cellule C1 contient la valeur 1.

Une combinaison de caractérisation est possible dans le CI, notamment dans l'hypothèse où d'autres CSP y seraient présentes. En supposant par exemple que la cellule C3 soit également en configuration de CSP et qu'il existe une dépendance entre la seconde porte 102, traversée par le chemin e2-o2 et la sortie de la cellule C3, deux types de signaux particuliers peuvent alors se combiner dans cette porte 102 et se propager sur la partie en aval du chemin e2-o2.

**Revendications**

**1.** Registre scan paramétrique comportant une cellule scan (21, C2) ayant au moins une entrée de donnée (d), apte à recevoir une donnée de test (e_scan), et transférant sur sa sortie (s) un signal représentatif (62) de la donnée d'entrée au moyen d'un signal de synchronisation (h), la cellule scan (21, C2) comportant un bloc de test paramétrique (42) dont une entrée est reliée à la sortie (s) de la cellule scan (21), **caractérisé en ce que** le signal de sortie (62) de la cellule scan étant transféré en sortie (s_reg) du bloc (42) à travers un module interne (61), ce module interne fonctionne selon des modes aptes à modifie les propriétés du signal de sortie (62) de la cellule scan.

2. Registre selon la revendication 1, **caractérisé en ce que** la sortie (s_reg) du bloc de test paramétrique (42) forme la sortie de la cellule.

3. Registre selon l'une quelconque des revendications précédentes, **caractérisé en ce que** dans un mode de fonctionnement, le module interne (61) applique un retard sur le signal de sortie (62) de la cellule.

4. Registre selon la revendication 3, **caractérisé en ce que** dans un mode de fonctionnement le module (61) applique un retard (Tm) sur l'état transitoire du signal de sortie (62) de la cellule.

5. Registre selon la revendication 4, **caractérisé en ce que** dans un mode de fonctionnement le module (61) applique un retard infini sur le signal de sortie (62) de la cellule.

6. Registre selon l'une quelconque des revendications précédentes, **caractérisé en ce que** dans un mode de fonctionnement le module interne (61) applique une modification d'amplitude du signal de sortie (62) du de la cellule.

7. Registre selon l'une quelconque des revendications précédentes, **caractérisé en ce que** le bloc de test paramétrique (42) comporte un module de génération de signaux arbitraires (91), ces signaux étant transférés sur la sortie (s_reg) du bloc (42).

8. Registre selon la revendication 7, **caractérisé en ce que** les signaux générés par le module (91) sont transférés sur la sortie (s_reg) du bloc (42) à travers le module interne (61) de modification de signaux.

9. Registre selon l'une quelconque des revendications 7 ou 8, **caractérisé en ce que** la sortie (s_reg) du bloc de test paramétrique (42) est issue de la sortie d'un multiplexeur (92), une entrée du multiplexeur recevant un signal arbitraire généré par un générateur externe (94).

10. Registre selon l'une quelconque des revendications précédentes, **caractérisé en ce qu'**il comporte en entrée un multiplexeur (32) dont la sortie est reliée à l'entrée (d) de la cellule (21), une entrée (D1) du multiplexeur recevant la donnée de test (e_scan), la donnée de test (e_scan) étant sélectionnée en sortie du multiplexeur (32) par une entrée de contrôle (ctrl_NormTest).

11. Circuit intégré numérique, **caractérisé en ce qu'**il comporte au moins un registre scan paramétrique selon l'une quelconque des revendications précédentes.

12. Circuit intégré numérique selon la revendication 11, **caractérisé en ce qu'**il comporte un contrôleur (33) générant des signaux de sélection des modes de fonctionnement du bloc de test paramétrique (42).

13. Circuit intégré numérique selon les revendications 10 et 12, **caractérisé en ce que** le contrôleur (33) génère le signal de contrôle (ctrl_NormTest) du multiplexeur d'entrée (32).

14. Procédé de test d'un circuit intégré numérique, ledit circuit comportant des cellules scan (C1, C2, C3) dont au moins une cellule scan formant un registre scan paramétrique selon l'une quelconque des revendications 1 à 11, **caractérisé en ce qu'**il comporte au moins les étapes suivantes :

    - charger au moins un vecteur de test (0, 1, 1) dans les cellules (C1, C2, C3) ;
    - sélectionner un mode de fonctionnement du bloc de test paramétrique (42) équipant la cellule scan (C2) formant un registre scan paramétrique ;
    - valider le mode de fonctionnement pour modifier le signal d'entrée (62) du bloc (42) avant sa propagation dans le circuit numérique ;
    - analyser le signal (100) en sortie du chemin sous test.

15. Procédé de test selon la revendication 14, **caractérisé en ce qu'**il comporte en outre une étape supplémentaire entre l'étape de validation du mode de fonctionnement et l'étape d'analyse du signal en sortie du chemin sous test, cette étape consistant à charger un vecteur de sensibilisation pour agir sur la commutation de ou des cellules formant un registre scan paramétrique.

**Claims**

1. A parametric scan register comprising a scan cell (21, C2) having at least one data input (d), able to receive a test datum (e_scan), and transferring to its output (s) a representative signal (62) indicative of the input datum by means of a synchronization signal (h), **characterized in that** the scan cell (21, C2) comprises a parametric test block (42) one input of which is linked to the output (s) of the scan cell (21), the output signal (62) of the scan cell being transferred at the output (s_reg) of the block (42) through an internal module (61), this internal module operating according to modes able to modify the properties of the output signal (62) of the scan cell.

2. The register as claimed in claim 1, **characterized in that** the output (s_reg) of the parametric test block (42) forms the output of the cell.

3. The register as claimed in any one of the preceding claims, **characterized in that** in one operating mode, the internal module (61) applies a delay to the output signal (62) of the cell.

4. The register as claimed in claim 3, **characterized in that** in one operating mode the module (61) applies a delay (Tm) to the transient state of the output signal (62) of the cell.

5. The register as claimed in claim 4, **characterized in that** in one operating mode the module (61) applies an infinite delay to the output signal (62) of the cell.

6. The register as claimed in any one of the preceding claims, **characterized in that** in one operating mode the internal module (61) applies an amplitude modification of the output signal (62) of the cell.

7. The register as claimed in any one of the preceding claims, **characterized in that** the parametric test block (42) comprises a module for generating arbitrary signals (91), these signals being transferred to the output (s_reg) of the block (42).

8. The register as claimed in claim 7, **characterized in that** the signals generated by the module (91) are transferred to the output (s_reg) of the block (42) through the internal module (61) for modifying signals.

9. The register as claimed in either one of claims 7 or 8, **characterized in that** the output (s_reg) of the parametric test block (42) arises from the output of a multiplexer (92), an input of the multiplexer receiving an arbitrary signal generated by an external generator (94).

10. The register as claimed in any one of the preceding claims, **characterized in that** it comprises at input a multiplexer (32) whose output is linked to the input (d) of the cell (21), an input (D1) of the multiplexer receiving the test datum (e_scan), the test datum (e_scan) being selected at the output of the multiplexer (32) by a control input (ctrl_ NormTest).

11. A digital integrated circuit, **characterized in that** it comprises at least one parametric scan register as claimed in any one of the preceding claims.

12. The digital integrated circuit as claimed in claim 11, **characterized in that** it comprises a controller (33) generating signals for selecting the operating modes of the parametric test block (42).

13. The digital integrated circuit as claimed in claims 10 and 12, **characterized in that** the controller (33) generates the control signal (ctrl_NormTest) for the input multiplexer (32).

14. A method of testing a digital integrated circuit, said circuit comprising scan cells (C1, C2, C3) at least one scan cell of which forms a parametric scan register as claimed in any one of claims 1 to11, **characterized in that** it comprises at least the following steps:

    - loading at least one test vector (0, 1, 1) into the cells (C1, C2, C3);
    - selecting an operating mode of the parametric test block (42) equipping the scan cell (C2) forming a parametric scan register;
    - validating the operating mode so as to modify the input signal (62) of the block (42) before its propagation in the digital circuit;

- analyzing the signal (100) at the output of the path under test.

15. The test method as claimed in claim 14, **characterized in that** it furthermore comprises an additional step between the step of validating the operating mode and the step of analyzing the signal at the output of the path under test, this step consisting in loading a sensitization vector so as to act on the switching of the cell or cells forming a parametric scan register.

**Patentansprüche**

1. Parametrisches Scan-Register, das eine Scan-Zelle (21, C2) umfasst, die wenigstens einen Dateneingang (d) zum Empfangen von Prüfdaten (e_scan) aufweist und zu ihrem Ausgang (s) ein für die Eingangsdaten repräsentatives Signal (62) mittels eines Synchronisationssignals (h) überträgt, wobei die Scan-Zelle (21, C2) einen parametrischen Prüfblock (42) umfasst, der einen mit dem Ausgang (s) der Scan-Zelle (21) verbundenen Eingang hat, **dadurch gekennzeichnet, dass** das Ausgangssignal (62) der Scan-Zelle über ein internes Modul (61) zum Ausgang (s_reg) des Blocks (42) übertragen wird, wobei dieses interne Modul in Betriebsarten arbeitet, die die Eigenschaften des Ausgangssignals (62) der Scan-Zelle modifizieren können.

2. Register nach Anspruch 1, **dadurch gekennzeichnet, dass** der Ausgang (s_reg) des parametrischen Prüfblocks (42) den Ausgang der Zelle bildet.

3. Register nach einem der vorherigen Ansprüche, **dadurch gekennzeichnet, dass** das interne Modul (61) in einer Betriebsart eine Verzögerung auf das Ausgangssignal (62) der Zelle appliziert.

4. Register nach Anspruch 3, **dadurch gekennzeichnet, dass** das Modul (61) in einer Betriebsart eine Verzögerung (Tm) auf den Übergangszustand des Ausgangssignals (62) der Zelle anwendet.

5. Register nach Anspruch 4, **dadurch gekennzeichnet, dass** das Modul (61) in einer Betriebsart eine unendliche Verzögerung auf das Ausgangssignal (62) der Zelle anwendet.

6. Register nach einem der vorherigen Ansprüche, **dadurch gekennzeichnet, dass** das interne Modul (61) in einer Betriebsart eine Modifikation der Amplitude des Ausgangssignals (62) der Zelle anwendet.

7. Register nach einem der vorherigen Ansprüche, **dadurch gekennzeichnet, dass** der parametrische Prüfblock (42) ein Modul zum Erzeugen von arbiträren Signalen (91) umfasst, wobei diese Signale zum Ausgang (s_reg) des Blocks (42) übertragen werden.

8. Register nach Anspruch 7, **dadurch gekennzeichnet, dass** die vom Modul (91) erzeugten Signale über das interne Signalmodifikationsmodul (61) zum Ausgang (s_reg) des Blocks (42) übertragen werden.

9. Register nach Anspruch 7 oder 8, **dadurch gekennzeichnet, dass** der Ausgang (s_reg) des parametrischen Prüfblocks (42) vom Ausgang eines Multiplexers (92) ausgegeben wird, wobei ein Eingang des Multiplexers ein von einem externen Generator (94) erzeugtes arbiträres Signal empfängt.

10. Register nach einem der vorherigen Ansprüche, **dadurch gekennzeichnet, dass** es am Eingang einen Multiplexer (32) umfasst, dessen Ausgang mit dem Eingang (d) der Zelle (21) verbunden ist, wobei ein Eingang (D1) des Multiplexers die Prüfdaten (e_scan) empfängt, wobei die Prüfdaten (e_scan) am Ausgang des Multiplexers (32) von einem Prüfeingang (ctrl_NormTest) ausgewählt werden.

11. Digitale integrierte Schaltung, **dadurch gekennzeichnet, dass** sie wenigstens ein parametrisches Scan-Register nach einem der vorherigen Ansprüche umfasst.

12. Digitale integrierte Schaltung nach Anspruch 11, **dadurch gekennzeichnet, dass** sie ein Prüfglied (33) umfasst, das Signale zum Auswählen der Betriebsarten des parametrischen Prüfblocks (42) erzeugt.

13. Digitale integrierte Schaltung nach einem der Ansprüche 10 und 12, **dadurch gekennzeichnet, dass** das Prüfglied (33) das Prüfsignal (ctrl_NormTest) des Eingangsmultiplexers (32) erzeugt.

**14.** Verfahren zum Prüfen einer digitalen integrierten Schaltung, wobei die Schaltung Scan-Zellen (C1, C2, C3) umfasst, von denen wenigstens eine ein parametrisches Scan-Register nach einem der Ansprüche 1 bis 11 umfasst, **dadurch gekennzeichnet, dass** es wenigstens die folgenden Schritte beinhaltet:

- Laden von wenigstens einem Prüfvektor (0, 1, 1) in die Zellen (C1, C2, C3);
- Auswählen einer Betriebsart des parametrischen Prüfblocks (42), mit dem die Scan-Zelle (C2) ausgestattet ist, die ein parametrisches Scan-Register bildet;
- Validieren der Betriebsart zum Modifizieren des Eingangssignals (62) des Blocks (42) vor seiner Ausbreitung in der digitalen Schaltung;
- Analysieren des Signals (100) am Ausgang des geprüften Pfads.

**15.** Verfahren nach Anspruch 14, **dadurch gekennzeichnet, dass** es darüber hinaus einen Ergänzungsschritt zwischen dem Validierungsschritt der Betriebsart und dem Schritt des Analysierens des Signals am Ausgang des geprüften Pfades beinhaltet, wobei dieser Schritt darin besteht, einen Sensibilisierungsvektor zum Wirken auf die Kommutation der Zelle(n) zu laden, die ein parametrisches Scan-Register bildet/bilden.

FIG.1

n entrées
3

entrées secondaires
11

(n-r)

(r)

C
1

R
2

10

CI

(r)

12
sorties secondaires

(k-r)

sorties
4

EP 2 069 814 B1

sortie secondaire     entrée secondaire

d        s

horloge      h

21

**FIG.2**

$e\_comb$

32

D0

$e\_scan$      D1

0
1

$ctrl\_NormTest$

horloge

d        s

h

$s\_reg$

11

D1

21

31

**FIG.3**

FIG.4

EP 2 069 814 B1

FIG.5

FIG.7

EP 2 069 814 B1

FIG.6

FIG.8

EP 2 069 814 B1

FIG.9

EP 2 069 814 B1

FIG.10

EP 2 069 814 B1

EP 2 069 814 B1

| | | | |
|:---:|:---:|:---:|:---:|
| X ~C3 | X ~C3 | X ~C3 | 0 ~C3 |
| X ~C2 | X ~C2 | 0 ~C2 | 1 ~C2 |
| X ~C1 | 0 ~C1 | 1 ~C1 | 1 ~C1 |
| t | t + H | t + 2 H | t + 3 H |

**FIG.11**

FIG.12

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2003208708 A1

**Littérature non-brevet citée dans la description**

- **C. Landrault.** Test de Circuits et de Systèmes Intégrés. Editions Lavoisier, 2004, 60-62
- **M.A. Breuer.** The Effects of Races, Delays and Delay Faults on Test Generation. *IEEE Trans. On Computers,* Octobre 1974, vol. 23, 1078-1092
- **M. William.** Enhancing testability of LSI Circuits via Test Points and Additional Logic. *IEEE Trans. On Computers,* Janvier 1973, vol. C-22 (1
- **E.F. Moore.** Sequential Machines : Selected Papers. Addison Wesley, 1964